# EUROPEAN PATENT SPECIFICATION

(11) **EP 0 286 384 B1**
(45) Date of publication and mention of the grant of the patent: **30.11.1994**
(21) Application number: 88303074.4
(22) Date of filing: 06.04.1988
(51) Int. Cl.: H02P 7/29, H02M 7/527, H03K 7/08

(54) **Switch mode electrical power controller**
Elektrischer Leistungschaltregler
Régulateur électrique de puissance à commutation

(30) Priority: 09.04.1987 GB 8708504
(43) Date of publication of application: 12.10.1988
(60) Divisional application: 94106855.3
(73) Proprietor: SEAGATE MICROELECTRONICS LIMITED, Edinburgh (GB)
(72) Inventor: Martin-Lopez, Fernando Ramon, Edinburgh, EH3 6LB (GB)
(74) Representative: Darby, David Thomas

(56) References cited:
- EP-A- 0 182 621
- DE-A- 3 227 296
- GB-A- 1 205 923
- US-A- 3 902 140
- US-A- 3 978 424
- IBM TECHNICAL DISCLOSURE BULLETIN, vol. 25, no. 3A, August 1982, page 1057, New York, USA; C.D. DRISCOLL: "Pulse-width Modulator"
- PATENT ABSTRACTS OF JAPAN, vol. 6, no. 99 (E-111)(977), 8 June 1982; & JP-A- 57 032126

## Description

The present invention relates to a switch mode electrical power controller.

Switch mode electrical power controllers are used in electrical power supplies. An electrical power supply for an electrical system including active semiconductor or vacuum devices is usually required to provide a substantially constant output voltage from a rectified alternating voltage while an electrical power supply for an electrical motor may be required to provide a variable output voltage for the control of the motor speed. Thus the controller for an electrical power supply may be required to provide for either the generation of a stabilised output voltage or a variable output voltage from an unstabilised input voltage.

An electrical power supply employing a switch mode controller operates by chopping the input voltage, passing to its output port either the full input voltage or zero voltage. The periods with a non-zero output voltage alternate with those of zero output voltage and the ratio of the two periods is varied as required to make the long term average voltage equal to the desired output voltage.

A pulse width modulator circuit for a switching regulator is disclosed in German Patent Application No. 32 27 296. The pulse width modulator circuit includes a first comparator which compares an input signal with a sawtooth wave signal, a second comparator which compares a reference voltage with the sawtooth wave signal, an AND circuit receiving the outputs from the first and second comparators, and a reference voltage generator having a series connection of first and second resistors, a reference voltage output terminal being connected to the connection point between the resistors and a capacitor connected in parallel with one of the resistors; it is preferable to connect a switch circuit so that the reference voltage output may be lowered by an electrical switching signal.

A two-phase pulse generator is disclosed in United States Patent No. 3 978 424. The two-phase pulse generator includes a first triangular signal generator in the form of a closed loop oscillator, a second triangular signal generator for generating a signal which is inverted with respect to the first triangular signal and a pair of comparators for comparing the respective triangular wave signals with a common control signal representative of a control requirement. Two-phase pulse signals are obtained from the respective comparators and the time duration of each of the pulse signals is proportional to the common control signal.

One of the advantages of a switch mode electrical power supply over other forms of electrical power supply is that the operating frequency may, within limits, be selected, and the fact that the energy storage components become smaller as the operating frequency is increased permits some control over the size of the power supply.

An object of the present invention is the provision of a switch mode electrical power controller capable of operation at higher frequencies than existing switch mode electrical power controllers.

The invention provides a switch mode electrical power controller including a signal generator which, in operation, provides a repetitively occurring ramp waveform signal, a signal processing network and input means for receiving a control signal that represents a required output voltage from a power supply, the signal processing network including means capable of performing pulse width modulation by combining the ramp waveform signal, the control signal and at least one other signal and providing from the combination a repetitive output signal having a first level for a first part of its period and a second level for the remainder of its period, characterised in that the generator is such as to provide a ramp waveform signal having alternate sloping and constant level portions, in which each sloping portion extends above and below the adjacent constant level portions to which it is joined by abrupt transitions.

In a first arrangement of the controller, the signal processing network includes a comparator having a first input port connected to receive the output signal from the generator and a second input port connected to receive the control signal, the comparator including means for causing it to switch regeneratively to provide the output signal changes and means for resetting it to provide an output signal at the first level on the occurrence of the abrupt transition at the beginning of each ramp waveform.

Preferably, in the first arrangement of the controller, the comparator includes a feedback network for effecting the regenerative switching and a feedforward network connected between its input and output regions for resetting it on the occurrence of the abrupt transition at the beginning of each ramp waveform and, preferably, the feedback network includes output regions of the comparator.

In a second arrangement of the controller the signal processing network includes an output stage connected directly to the comparator output port, a feedback network connected to the comparator and to the output stage for causing the output stage to switch regeneratively and a feedforward network connected between the input and output regions of the comparator for resetting the comparator on the occurrence of the abrupt transition at the beginning of each ramp waveform and, preferably, the feedback network includes input regions of the output stage.

In either arrangement of the controller, the signal processing network can include similar first and second channels, for providing respective first and second output signals on the first and second channels, and commutation and blanking networks connected in shunt with the signal processing network for selecting either the first or the second output signal for transmission to an output port of the controller.

Alternatively, in either arrangement of the controller, the signal processing network can include first and second channels for providing respective first and second output signals on the first and second channels, and a commutation network connected in shunt with the signal processing network for combining the first and second output signals for transmission to an output port of the controller.

In either arrangement of the controller, the signal processing network can include current and voltage limit protection networks connected in shunt with the remainder of the signal processing network.

Preferably, in either arrangement of the controller, the signal processing network includes a plurality of differentially-connected transistor stages with common-node input ports, differential mode input ports, and differential mode output ports.

Preferably, in either arrangement of the controller the signal generator is a non-saturating emitter-coupled multivibrator which is connected to provide the signal processing network with the ramp signal having alternate sloping and constant level portions joined by abrupt transitions.

Either arrangement of the controller can include a signal level setting network connected to adjust the control signal range.

The invention relates to the use, in a switch mode electrical power controller, of a signal generator that provides a repetitively occurring ramp waveform signal having alternate sloping and constant level portions, in which each sloping portion extends above and below the adjacent constant level portions to which it is joined by abrupt transitions, the ramp waveform signal being applied along with a control signal, that represents a required output voltage from a power supply, and at least one other signal to means of a signal processing network capable of performing pulse width modulation by combining those signals and providing from the combination a repetitive output signal having a first level for a first part of its period and a second level for the remainder of its period.

A switch mode electrical power controller in accordance with the present invention will now be described by way of example only and with reference to the accompanying drawings, in which:-
Fig. 1 is a block diagram representation of a first form of switch mode electrical power controller, in accordance with the present invention, including a ramp waveform generator, a signal processing network with two channels, and an output stage connected to each channel of the signal processing network,
Fig. 2 is a diagrammatic representation of the waveforms provided by the ramp waveform generator, the signal processing network, and the output stages of the controller of Fig. 1,
Fig. 3 is a circuit diagram representation of the ramp waveform generator of Fig. 1,
Fig. 4 is a diagrammatic representation of the ramp waveforms provided by the ramp waveform generator of Fig. 3,
Fig. 5 is a block diagram representation of a second form of switch mode electrical power controller, in accordance with the present invention, in which the signal processing network and the output stages are arranged differently from the signal processing network and output stages of Fig. 1,
Fig. 6 is a circuit diagram representation of part of the signal processing network of Fig. 5 capable of carrying out the functions of pulse-width modulation and output signal switching, latching, and resetting,
Fig. 7 is a circuit diagram representation of another part of the signal processing network of Fig.5 capable of carrying out the circuit functions of commutation and blanking,
Fig. 8 is a circuit diagram representation of an arrangement of the signal processing network for providing a single-ended output from the controller, and,
Fig. 9 is a circuit diagram representation of a signal level setting network included in both the first and second forms of the power controller.

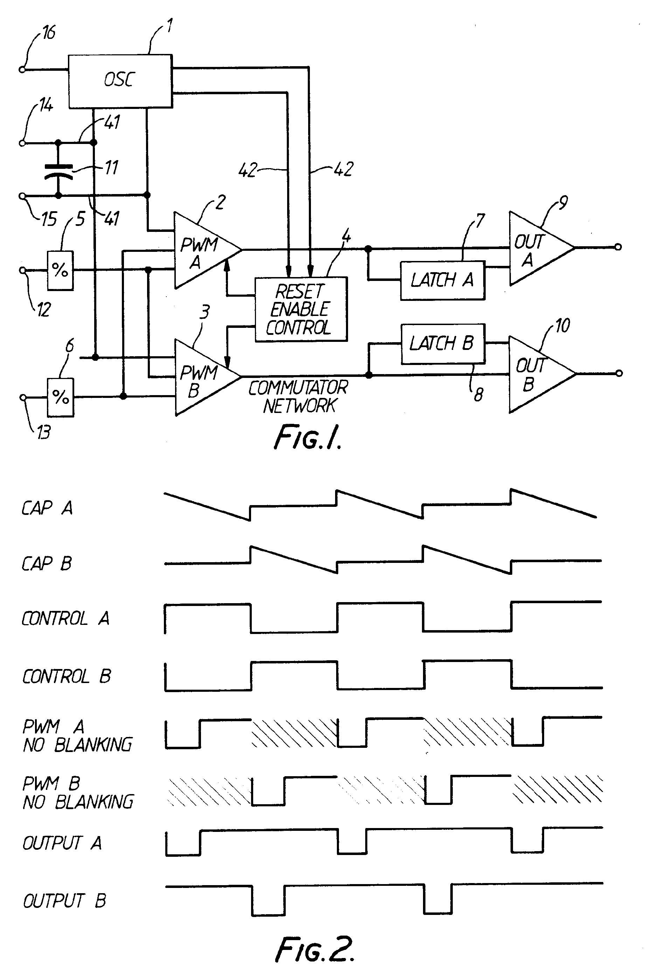

Referring to Fig. 1, the first form of the switch mode electrical power controller includes a ramp generating oscillator 1, two pulse-width modulators 2 and 3, a control network 4, signal level setting networks 5 and 6, two latching networks 7 and 8, and two output stages 9 and 10, and an external capacitor. The capacitor 11 is required for the oscillator 1.

Referring to Fig. 1, the oscillator 1 has output ports connected to input ports of the pulse-width modulators 2 and 3, and a further output port connected to the control network 4. The control network 4 has output ports connected to the pulse-width modulators 2 and 3. The pulse-width modulator 2 has an output port connected directly to the output stage 9 and the latching network 7 is connected internally to the output stage 9 and to the output port of the pulse-width modulator 2. The pulse-width modulator 3, the output stage 10, and the latching network 8 are connected together in the same manner as the pulse-width modulator 2, the output stage 9, and the latching network 7, are connected together. The signal level setting network 5 is connected between a control input port 12 and an input port of the pulse-width modulator 2 and is connected also to an input port of the pulse-width modulator 3. The signal level setting network 6 is connected between a control input port 13 and the pulse-width modulators 2 and 3 in a manner similar to the connection of the level setting network 5 to the pulse width modulators 2 and 3.

The operation of the switch mode power controller of Fig. 1 may be understood by referring to Fig. 2 in which the waveforms labelled CAP A and CAP B represent the signals provided by the oscillator 1 at the input ports to the pulse-width modulators 2 and 3, the waveforms labelled CONTROL A and CONTROL B represent the signals provided by the control network 4 to the pulse-width modulators 2 and 3, the waveforms labelled PWMA and PWMB represent the output signals from the pulse-width modulators 2 and 3, and the waveforms labelled OUTPUT A and output B represent the signals from the output stages 9 and 10.

Referring to Fig. 2, the waveform CAP A includes alternate falling ramp portions and constant level portions and the waveform CAP B has the same form as the waveform CAP A but is shifted from it in time by a half-period of either waveform. The waveform PWM A is shown as having half-periods corresponding to the ramp portions of the waveform CAP A but is initially at a low level and changes abruptly to a high level during the existence of the ramp portion of the waveform CAP A. The change in the level of the waveform PWMA will occur at the time when the input signal on one of the control input ports 12 and 13 is such that the signal at a second of the input ports of the pulsewidth modulator 2 is equal to the ramp level, the waveform PWM A being low while the ramp level is the greater and the waveform being high while the ramp level is the lower, of the two signals. It will be appreciated that the ratio of the period for which the waveform PWM A is low to that when it is high will alter as the input signal on the port 12 or 13 varies. The level setting networks 5 and 6 are required to adjust the range of the signal appearing at the input ports of the pulse-width modulators 2 and 3 to match the amplitude of the ramp. The waveform PWM B is generated in a similar manner to that of PWMA. It will be noted that PWMA and PWMB are not shown for the period during which the waveforms CAP A and CAP B are constant for the reason that PWMA and PWMB are meaningful only during periods when CAPA and CAPB are ramp waveforms. The waveforms CONTROL A and CONTROL B are used to set the pulse-width modulators 2 and 3 to their respective high output level states, that is, to effect blanking during those periods when CAPA and CAP B are not ramp waveforms to provide the output waveforms OUTPUT A and OUTPUT B.

The output waveforms OUTPUT A and OUTPUT B may be combined to provide a single-ended output device or the waveforms OUTPUT A and OUTPUT B may be kept separate to provide a double-ended output device.

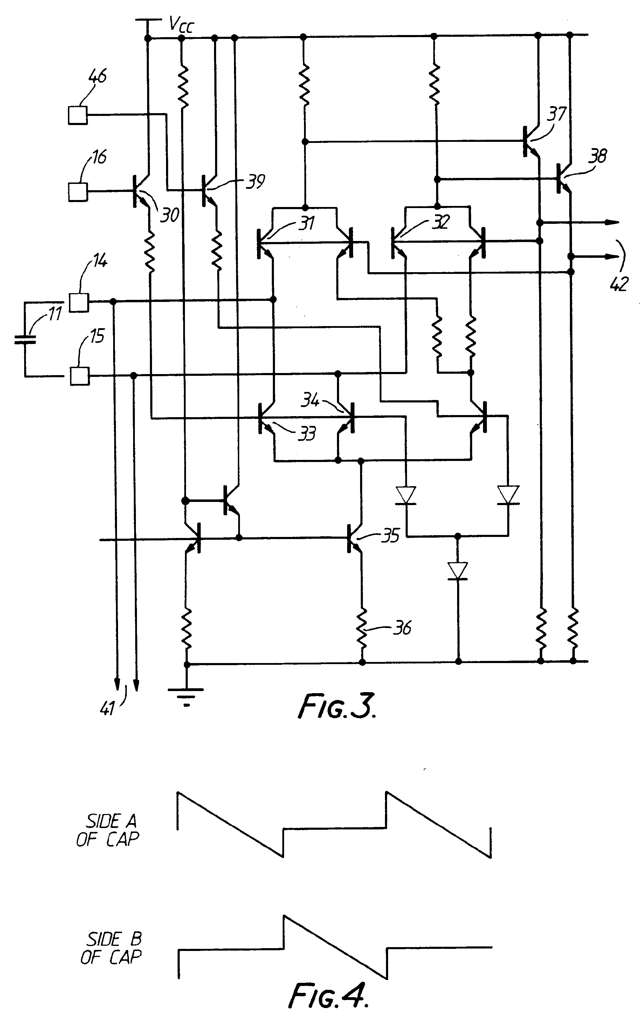

Fig. 3 is a circuit diagram representation of the oscillator of Fig. 1, and, referring to Fig. 3, the oscillator includes ports 14 and 15 between which are connected the frequency-determining capacitor (the capacitor 11 of Fig. 1). The oscillator is an integrated circuit form of a symmetrical non-saturating emitter coupled multivibrator in which the frequency-determining capacitor 11 is connected between the emitters of two transistors supplied by current sources and in which there are feedback connections between the transistors to cause oscillation, the two current source currents flowing first one way through the capacitor and then the other way through the capacitor to generate the ramp waveforms as the transistors switch alternately on and off (see Electronic Designer's Handbook by T. K. Hemingway pages 191 to 194). In Fig. 3, the capacitor 11 is connected to the emitters of the transistors 31 and 32 for which the transistors 33, 34 and 35 and the resistor 36 provide two current sources. The signals developed at the collector electrode of the transistor 31 are fed back to the base electrode of the transistor 32 by way of the transistor 37 and the signals at the collector electrode of the transistor 32 are fed back to the base electrode of the transistor 31, to provide cross-coupling between the output and input ports. The emitter electrode of the transistors 37 and 38 provide further. output ports for the oscillator.

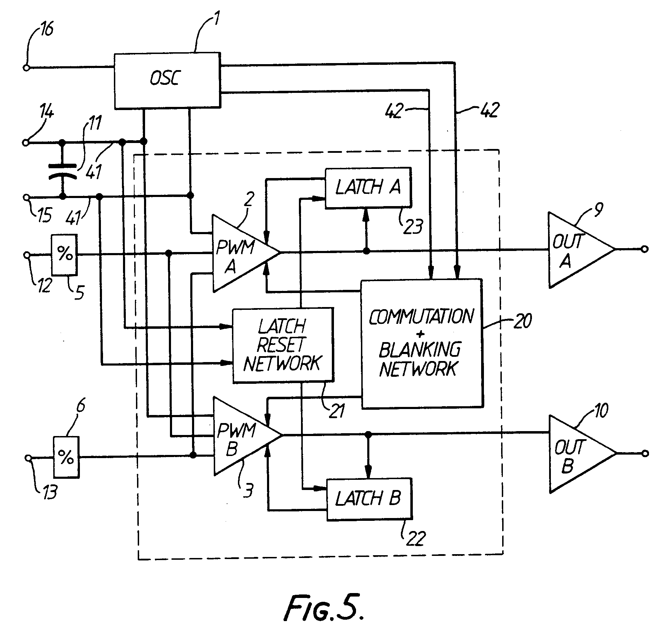

Referring to Fig. 4, waveforms of the output signals available from the port 14 of the oscillator is shown as the upper waveform, say, of Fig. 4, and the waveform of the output signal available from the port 15 of the oscillator is then the lower waveform of Fig. 4. As is evident from the two waveforms, the oscillator provides a signal in which a negative-going ramp alternates with a constant level about which the ramps are symmetrical. The waveforms of Fig. 4 are, of course, the same as the upper waveforms of Fig. 2. The oscillator includes a frequency-control input port 16 permitting control of the current source currents, and thereby the operating frequency, by way of a transistor 30.

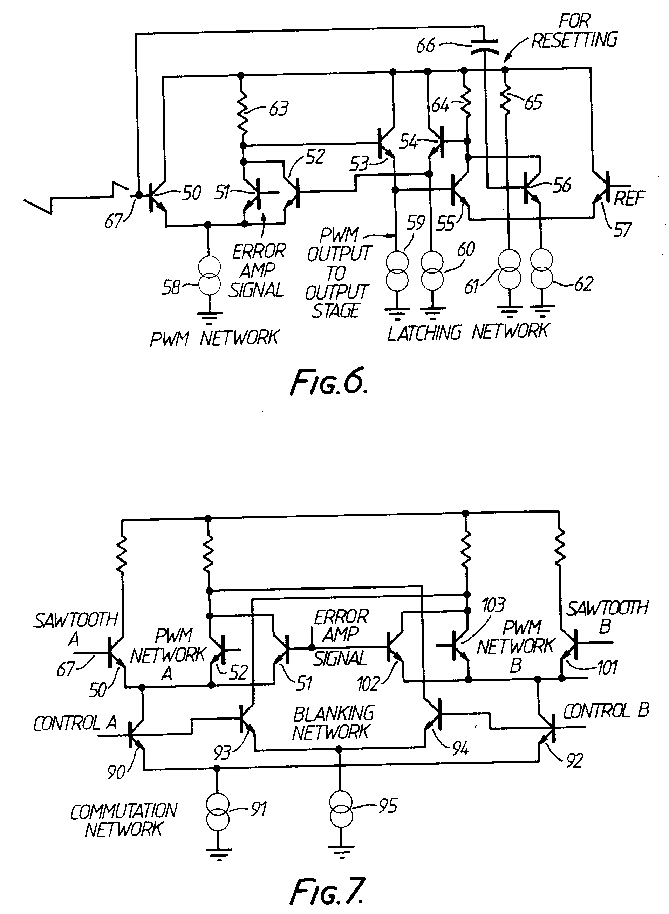

Referring to Fig. 5, the second form of the switch mode electrical controller includes, as for the first form represented by Fig. 1, a ramp generating oscillator 1, two pulse-width modulators 2 and 3, signal level setting networks 5 and 6, two output stages 9 and 10, and an external capacitor 11 required for the oscillator 1. The second form of the controller includes, connected to the oscillator 1 and the pulse-width modulators 2 and 3, a commutation and blanking network 20, two latching networks 22 and 23, and a latch reset network 21.

Referring to Fig. 5, the oscillator 1 has output ports connected to input ports of the pulse-width modulators 2 and 3, and a further output port connected to the commutation and blanking network 20. The commutation and blanking network 20 has output ports connected to the pulse-width modulators 2 and 3. The pulse-width modulator 2 has an output port connected directly to the output stage 9 and the latching network 23 is connected internally to the pulse-width modulator 2 and also to the output port of the pulse-width modulator 2. The latch reset network 21 has input ports connected also to the output ports of the oscillator 1 and an output port of the latch reset network 21 is connected to an input port of the latching network 23. The pulse-width modulator 3 has an output port connected directly to the output stage 10 and the latching network 22 is connected internally to the pulse-width modulator 3 and also to the output port of the pulse-width modulator 3. The latch reset network 21 has a further output port connected to an input port of the latching network 22. The signal level setting network 5 is connected between a control input port 12 and an input port of the pulse width modulator 2 and is connected also to an input port of the pulse width modulator 3. The signal level setting network 6 is connected between a control input port 13 and the pulse width modulators 2 and 3 in a manner similar to the connection of the level setting network 5 to the pulse-width modulators 2 and 3.

The operation of the second form of the switch mode power controller of Fig. 5 gives rise to the waveforms which are illustrated by Fig. 2, that is, the operation of the second form of the switch mode power controller is the same as that of the first form of the switch mode power controller.

Referring to fig. 6, a signal processing network includes first and second transistors 50 and 51 coupled together at their emitter electrodes and sharing a current source 58 connected to the coupled emitters. A third transistor 52 is connected in parallel with the transistor 51 to share its collector load resistor 63 and the current source 58. The collector electrodes of the transistors 51 and 52 are connected to the base electrode of a fourth transistor 53 which has a current source 59 connected as its emitter load and the emitter electrode of the transistor 53 is connected to the base electrode of a transistor 55 which has a current source emitter load 62, and a collector load resistor 64. The collector electrode of the transistor 55 is connected to the base electrode of a transistor 54 which has a current source emitter load 60, the emitter electrode of the transistor 54 being connected to the base electrode of the transistor 52. A transistor 56 is connected in parallel with the transistor 55 sharing the collector load resistor 64 and the emitter current source 62. The transistor 56 is biassed by means of a base resistor 65 connected between its base electrode and a positive voltage (which is the positive voltage supply for the other transistors) and a current source 61 connected between its base electrode and electrical ground. The base electrode of the transistor 56 is connected to the base electrode of the transistor 50 by way of a capacitor 66. A further transistor 57 has its emitter electrode connected to the current source 62, and its collector electrode connected to the positive supply for the other transistors. The base electrode of the transistor 57 is connected to a further resistor and a further current source similar to the connections of the base electrode of the transistor 56 to its resistor 65 and current source 61, but the further resistor and current source associated with the transistor 57 are not shown.

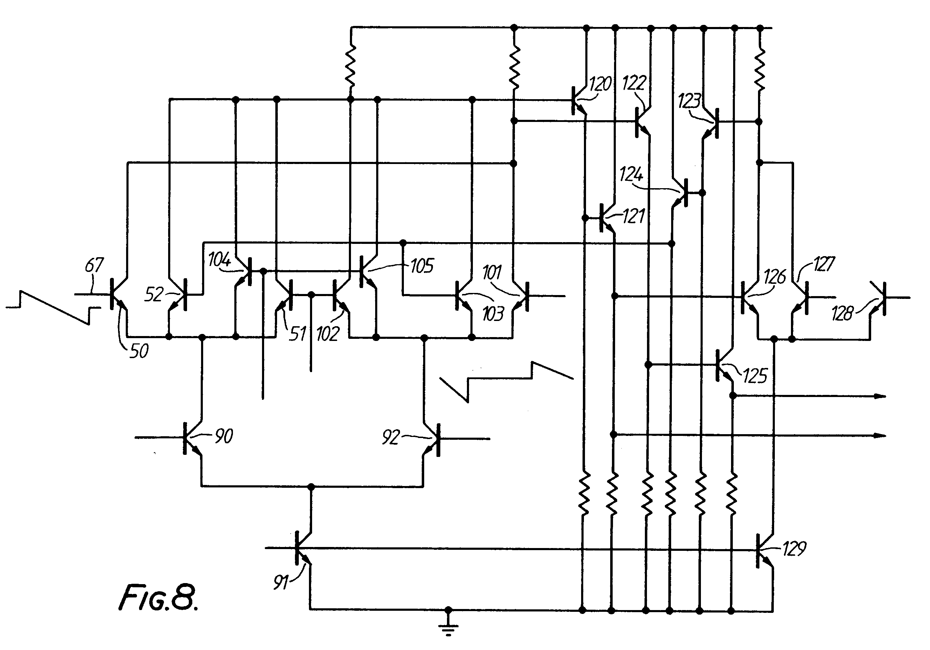

In the operation of the signal processing arrangement of Fig. 6, the base electrode of the transistor 50 receives a ramp waveform signal from the oscillator 1 of Fig. 1 while the base electrode of the transistor 51 receives a constant level signal which is an error voltage which will represent the difference between the desired and actual output voltages of a power supply to which the signal processing arrangement belongs. The ramp waveform has an initial rapid rise from the constant voltage level which precedes it and this jump in level is communicated, by way of the capacitor 66, to the base electrode of the transistor 56 causing an abrupt rise in its collector current and an abrupt drop in its collector voltage level, the collector voltage level drop being communicated to the base electrode of the transistor 52 by way of the transistor 54 to hold transistor 52 in a non-conducting state. Also the ramp voltage level will start higher than the error voltage and transistor 51 will be held in its non-conducting state so that the collectors of the transistors 51 and 52 will be at a high voltage level and the output voltage from the emitter electrode of the transistor 53 will be high. The output voltage will remain high as the ramp level falls but remains above the error signal level but as the ramp level goes below the error signal level the transistor 51 will begin to conduct and its collector voltage will drop. The drop in the collector voltage of the transistor 51 will be communicated to the transistors 53 and 55 as a voltage drop and to the transistors 54 and 52 as a voltage rise, causing a regenerative effect resulting in the rapid switch on of the transistor 52 and the latching of the feedback loop with the transistor 52 in its conducting state. In due course the transistor 51 will become fully conductive and will remain so to the end of the ramp waveform at which time the ramp waveform changes abruptly to the constant level which may lie below the error voltage level and as a result of which the transistor 51 may not be switched off and may cause the output voltage to remain low after the end of the ramp waveform so that the output state of the arrangement of Fig.6 is undefined during the period between the ramp waveforms. It is important that the output voltage from the signal processing arrangement should return to a high level at the end of the ramp waveform and this is ensured by the control of the current source 58 to switch off the transistor 51 at the end of the ramp waveform. Such control of the current source is illustrated by the Fig. 7 arrangement.

Referring to Fig. 7, a signal processing arrangement includes the "left-hand" transistors 50, 51 and 52 as described in Fig. 6 and corresponding "right-hand" transistors 101, 102 and 103 sharing a current source 91 connected in the emitter circuit of the transistors 50, 51 and 52 by way of of a transistor 90 and connected in the emitter circuit of the transistors 101, 102 and 103 by way of a transistor 92. The base electrode of the transistor 90 is connected to the base electrode of a transistor 93 the emitter electrode of which is connected to a current source 95 and the base electrode of the transistor 92 is connected to the base electrode of a transistor 94 the emitter electrode of which is also connected to the current source 95. The collector electrode of the transistor 93 is connected to the collector electrode of the transistors 102 and 103 and the collector electrode of the transistor 94 is connected to the collector electrode of the transistors 51 and 52.

In the operation of the signal processing arrangement of Fig. 7 , the base electrode of the transistor 90 is driven by the waveform CONTROL A of Fig. 2 and the base electrode of the transistor 92 is driven by the waveform CONTROL B of Fig. 2, the two waveforms being provided by the oscillator illustrated in Fig. 3 (the transistors 37 and 38 in Fig. 3 provide the waveforms CONTROL A and CONTROL B). It will be evident that the waveform CONTROL A will be such as to disable the stage comprising transistors 50, 51 and 52 by switching off transistor 90 during the periods when the CAP A waveform has a constant value, but the effect of the transistor 94 is superimposed on this and results in the collector voltage of the transistors 51 and 52 being held low, since the CONTROL B waveform controls the transistor 94. Similarly, the transistor 92 is driven by the CONTROL B waveform while the CONTROL A waveform drives the transistor 93, so the output signals from the left and right hand stages remain complementary and the stages operate alternately.

The signal processing arrangement of Fig.7 provides a dual output that is, an output for a double-ended controller. The signal processing arrangement of Fig.7, may be converted to provide a single output by the removal of the components 93, 94 and 95 and the connection, in parallel, of the two channels.

A circuit diagram representation of the circuit arrangement of Fig.7 modified to provide a single-ended output is shown in Fig. 8 where the stages comprising the transistors 120 to 127 corresponding generally to those parts of the signal processing network represented by Fig. 6, and the stages comprising the transistors 50, 51, 52, 104, 101, 102, 103 and 105 correspond to those parts of the signal processing network represented by Fig. 7. It is to be noted that the transistors 104 and 105 provide current limiting in this arrangement and perform their function in parallel with all the other functions.

Returning to Fig. 3, it will be noted that the oscillator frequency is controllable by way of the port 16, a practical effect of which is to permit the operation of a power supply equipped with a controller comprising the voltage controllable oscillator with a variable frequency. Such operation would be achieved by an arrangement in which an error voltage was applied to the port 16,as an alternative, or in addition to an error voltage applied to the pulse-width control input port.

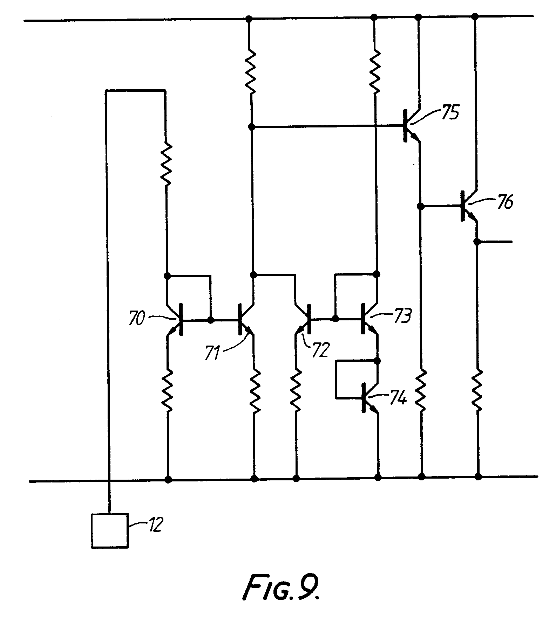

Referring to Fig. 9, a signal level setting network (either the network 5 or the network 6 of Fig. 1) includes a first NPN transistor 70 connected as a diode with associated collector and emitter electrode resistors, a second NPN transistor 71, connected base electrode to base electrode with the transistor 70, with its associated collector and emitter electrode resistors, a third NPN transistor 75, having its base electrode connected to the collector electrode of the transistor 71; with an associated emitter electrode resistor, and a fourth NPN transistor 76, having its base electrode connected to the emitter electrode of the transistor 75, with an associated emitter electrode resistor. A fifth NPN transistor 72 is connected collector electrode to collector electrode with the transistor 71, has an associated emitter electrode resistor, and is connected base electrode to base electrode with a sixth NPN transistor 73 which has its base and collector electrodes connected together. The transistor 73 has a collector electrode resistor and its emitter electrode is connected to a seventh NPN transistor 74 which has its base and collector electrodes connected together. The emitter electrode of the transistor 74 and the emitter electrode resistors of the transistors 70, 71, 72, 75 and 76 are connected together. Also, the collector electrode resistors of the transistors 71 and 73 are connected together and to the collector electrodes of the transistors 75 and 76. The collector electrode resistor of the transistor 70 is connected to the control input port 12, say, of Fig. 1.

In the operation of the level setting network of Fig. 9, an input control voltage to the port 12 produces a corresponding current in through the transistor 70 and its associated resistors, and the same amount of current flows through the transistor 71 and its associated emitter electrode resistor. The current flowing through the transistor 71 influences the voltage level at the junction of its collector electrode through its collector electrode resistor, and the transistors 75 and 76, which act as a compound emitter follower, communicate the voltage level of the collector electrode of the transistor 71 to the emitter electrode of the transistor 76. The emitter electrode of the transistor 76 is the output port of the level setting network. The collector voltage of the transistor 71 is also influenced by the current flowing through the transistor 72, the current flowing through the transistor 72 being set by the transistors 73 and 74 and the resistor associated with the collector electrode of the transistor 73. The output voltage level from the signal level setting circuit is therefore the combined result of a fixed current flowing through the transistor 72 and a signal-dependent current flowing through the transistor 71. The maximum output voltage level will be set by the fixed current when the signal-dependent current is zero and the minimum output voltage level will be set by the collector and emitter electrode resistors of the transistor 71, intermediate output voltage levels being in proportion to the signal applied to the control port 12 so long as the applied signal is below the value to cause the minimum output voltage levels. The arrangement of the active components in Fig. 9 is also temperature-compensated.

The level setting network of Fig. 9 provides level shifting for interfacing with the pulse width modulator 2 or 3 of Fig. 1. It also provides division by a factor of about 10 which is controlled by the ratio of the collector and emitter resistors of the transistor 70, and linearity and good control are achieved with a sawtooth excursion of about 1 Volt. An advantage of including the level setting network is that a large error amplifier output range may be used, giving good control through high sensitivity, while a match is maintained between the sawtooth waveform amplitude and the divided down error voltage.

## Claims

1. A switch mode electrical power controller including a signal generator (1) which, in operation, provides a repetitively occurring ramp waveform signal (CAP A), a signal processing network (2,4) (2,20) and input means (12) for receiving a control signal that represents a required output voltage from a power supply, the signal processing network (2,4) (2,20) including means (2) capable of performing pulse width modulation by combining the ramp waveform signal (CAP A), the control signal and at least one other signal (CONTROL A) and providing from the combination a repetitive output signal (OUTPUT A) having a first level for a first part of its period and a second level for the remainder of its period, characterised in that the generator (1) is such as to provide a ramp waveform signal (CAP A) having alternate sloping and constant level portions, in which each sloping portion extends above and below the adjacent constant level portions to which it is joined by abrupt transitions.

2. A controller as claimed in claim 1, wherein the signal processing network (2,4) (2,20) includes a comparator (50,51,63) having a first input port (67) connected to receive the signal (CAP A) from the generator and a second input port connected to receive the control signal, the comparator (50,51,63) including means (52,53,54,55,63) for causing it to switch regeneratively to provide the output signal changes and means (52,54,56,66) for resetting it to provide an output signal at the first level on the occurrence of the abrupt transition at the beginning of each ramp waveform. (CAP A).

3. A controller as claimed in claim 2, wherein the comparator (50,51,63) includes a feedback network (52,53,54,55,63) for effecting the regenerative switching and a feedforward network (52,54,56,66) connected between its input and output regions for resetting it on the occurrence of the abrupt transition at the beginning of each ramp waveform.
(CAP A).

4. A controller as claimed in claim 3, wherein the feedback network (52,53,54,55,63) includes output regions of the comparator (50,51,63).

5. A controller as claimed in claim 2, wherein the signal processing network (2,4,7,9) includes an output stage (9) connected directly to the comparator output port, a feedback network (7) connected to the comparator and to the output stage (9) for causing the output stage (9) to switch regeneratively and a feedforward network connected between the input and output regions of the comparator for resetting the comparator on the occurrence of the abrupt transition at the beginning of each ramp waveform.

6. A controller as claimed in claim 5, wherein the feedback network includes input regions of the output stage.

7. A controller as claimed in any one of claims 1 to 6, wherein the signal processing network (2,3,4) includes similar first and second channels, for providing respective first (OUTPUT A) and second (OUTPUT B) output signals on the first and second channels, and commutation and blanking networks (90,91,92,93,94,95) are connected in shunt with the signal processing network for selecting either the first (OUTPUT A) or the second (OUTPUT B) output signal for transmission to an output port of the controller.

8. A controller as claimed in any one of claims 1 to 6, wherein the signal processing network (2,3,4) includes first and second channels for providing respective first (OUTPUT A) and second (OUTPUT B) output signals on the first and second channels, and a commutation network (120,121,122,125)is connected in shunt with the signal processing network for combining the first (OUTPUT A) and second (OUTPUT B) output signals for transmission to an output port of the controller.

9. A controller as claimed in any one of claims 1 to 8, wherein the signal processing network includes current and voltage limit protection networks (104,105) and those networks are connected in shunt with the remainder of the signal processing network.

10. A controller as claimed in any one of claims 1 to 9, wherein the signal processing network includes a plurality of differentially-connected transistor stages with common-mode input ports, differential mode input ports, and differential mode output ports.

11. A controller as claimed in any one of claims 1 to 10, wherein the signal generator is a non-saturating emitter-coupled multivibrator (30 to 42) which is connected to provide the signal processing network with the ramp signal having alternate sloping and constant level portions joined by abrupt transitions.

12. A controller as claimed in any one of claims 1 to 11, including a signal level setting network (70 to 76) connected to adjust the control signal range.

13. The use, in a switch mode electrical power controller, of a signal generator (1) that provides a repetitively occurring ramp waveform signal (CAP A) having alternate sloping and constant level portions, in which each sloping portion extends above and below the adjacent constant level portions to which it is joined by abrupt transitions, the ramp waveform signal (CAP A) being applied along with a control signal, that represents a required output voltage form a power supply, and at least one other signal (CONTROL A) to means (2) of a signal processing network (2,4) (2,20) capable of performing pulse width modulation by combining those signals and providing from the combination a repetitive output (OUTPUT A) signal having a first level for a first part of its period and a second level for the remainder of its period.

## Patentansprüche

1. Ein geschaltetes elektrisches Leistungssteuergerät, umfassend einen Signalgenerator (1), der im Betrieb ein wiederholt auftretendes Rampen-Wellenformsignal (CAP A) liefert, ein Signalverarbeitungsnetzwerk (2,4) (2,20) und Eingangsmittel (12) für den Empfang eines Steuersignals, das eine geforderte Ausgangsspannung von einer Leistungsversorgung repräsentiert, wobei das Signalverarbeitungsnetzwerk (2,4) (2,20) Mittel (2) umfaßt, die eine Pulsbreitenmodulation auszuführen in der Lage sind mittels Kombination des Rampen-Wellenformsignals (CAP A), des Steuersignals und mindestens eines anderen Signals (CONTROL A), und aus der Kombination ein sich wiederholendes Ausgangssignal (OUTPUT A) erzeugt mit einem ersten Pegel für einen ersten Teil seiner Periode und einem zweiten Pegel für den Rest seiner Periode, dadurch gekennzeichnet, daß der Generator (1) derart ist, daß er ein Rampen-Wellenformsignal (CAP A) liefert mit alternierenden Sägezahn- und Konstantpegelabschnitten, wobei jeder Sägezahnabschnitt sich über und unter die benachbarten Konstantpegelabschnitte erstreckt, mit denen er über abrupte Transitionen verbunden ist.

2. Ein Steuergerät nach Anspruch 1, bei dem das Signalverarbeitungsnetzwerk (2,4) (2,20) einen Komparator (50,51,63) umfaßt mit einem ersten Eingang (67), angeschlossen zum Empfang des Signals (CAP A) von dem Generator, und einem zweiten Eingang, verbunden zum Empfang des Steuersignals, welcher Komparator (50,51,63) Mittel (52,53,54,55,63) umfaßt, um ihn regenerativ schalten zu lassen zum Bereitstellen der Ausgangssignaländerungen, und Mittel (52,54,56,66) umfaßt für sein Zurücksetzen zum Bereitstellen eines Ausgangssignals auf dem ersten Pegel bei Auftreten der abrupten Transition zu Beginn jeder Rampen-Wellenform (CAP A).

3. Ein Steuergerät nach Anspruch 2, bei dem der Komparator (50, 51,63) ein Rückkopplungsnetzwerk (52,53,54,55,63) umfaßt für das Bewirken des regenerativen Schaltens und ein Mitkopplungsnetzwerk (52,54, 56,66), angeschlossen zwischen seinem Eingang und Ausgangsbereichen für sein Rücksetzen bei Auftreten der abrupten Transition zu Beginn jeder Rampen-Wellenform (CAP A).

4. Ein Steuergerät nach Anspruch 3, bei dem das Rückkopplungsnetzwerk (52,53,54,55,63) Ausgangsbereiche des Komparators (50,51,63) umfaßt.

5. Ein Steuergerät nach Anspruch 2, bei dem das Signalverarbeitungsnetzwerk (2,4,7,9) eine Ausgangsstufe (9) umfaßt, die direkt an den Komparatorausgang angeschlossen ist, wobei ein Rückkopplungsnetzwerk (7) mit dem Komparator und der Ausgangsstufe (9) verbunden ist für das regenerative Schaltenlassen der Ausgangsstufe (9), und ein Mitkopplungsnetzwerk, angeschlossen zwischen dem Eingang und den Ausgangsbereichen des Komparators für das Rücksetzen des Komparators bei Auftreten der abrupten Transition zu Beginn jeder Rampen-Wellenform.

6. Ein Steuergerät nach Anspruch 5, bei dem das Rückkopplungsnetzwerk Eingangsbereiche der Ausgangsstufe umfaßt.

7. Ein Steuergerät nach einem der Ansprüche 1 bis 6, bei dem das Signalverarbeitungsnetzwerk (2,3,4) ähnliche erste und zweite Kanäle umfaßt für das Bereitstellen entsprechender erster (OUTPUT A) und zweiter (OUTPUT B) Ausgangssignale auf dem ersten und dem zweiten Kanal, und Umschalt- und Unterdrückungsnetzwerke (90,91,92,93,94,95) parallelgeschaltet sind zu dem Signalverarbeitungsnetzwerk für das Auswählen entweder des ersten (OUTPUT A) oder des zweiten (OUTPUTB B) Ausgangssignals für die übertragung zu einem Ausgang des Steuergeräts.

8. Ein Steuergerät nach einem der Ansprüche 1 bis 6, bei dem das Signalverarbeitungsnetzwerk (2,3,4) erste und zweite Kanäle umfaßt für das Bereitstellen entsprechender erster (OUTPUT A) und zweiter (OUTPUT B) Ausgangssignale auf dem ersten beziehungsweise zweiten Kanal, und bei dem ein Umschaltnetzwerk (120,121,122,125) dem Signalverarbeitungsnetzwerk parallelgeschaltet ist für das Kombinieren der ersten (OUTPUT A) und zweiten (OUTPUT B) Ausgangssignale für die Übertragung zu einem Ausgang des Steuergeräts.

9. Ein Steuergerät nach einem der Ansprüche 1 bis 8, bei dem das Signalverarbeitungsnetzwerk Strom- und Spannungsbegrenzungsschutznetzwerke (104,105) umfaßt und jene Netzwerke dem Rest des Signalverarbeitungsnetzwerks parallelgeschaltet sind.

10. Ein Steuergerät nach einem der Ansprüche 1 bis 9, bei dem das Signalverarbeitungsnetzwerk eine Mehrzahl von differentialgeschalteten Transistorstufen umfaßt mit einem Gleichtakteingang, Differentialmoduseingang und Differentialmodusausgang.

11. Ein Steuergerät nach einem der Ansprüche 1 bis 10, bei dem der Signalgenerator ein nichtsättigender, emittergekoppelter Multivibrator (30 bis 42) ist, der angeschlossen ist zum Ansteuern des Signalverarbeitungsnetzwerks mit dem Rampensignal mit alternierenden Sägezahn- und Konstantpegelabschnitten, verbunden durch abrupte Transitionen.

12. Ein Steuergerät nach einem der Ansprüche 1 bis 11 einschließlich eines Signalpegelsetznetzwerkes (70 bis 76), angeschlossen zum Justieren des Steuersignalbereichs.

13. Die Verwendung in einem geschalteten elektrischen Leistungssteuergerät eines Signalgenerators (1), der ein repetitiv auftretendes Rampen-Wellenformsignal (CAP A) mit alternierenden Sägezahn- und Konstantpegelabschnitten liefert, wobei jeder Sägezahnabschnitt sich über und unter die benachbarten Konstantpegelabschnitte erstreckt, mit denen er über abrupte Transitionen verbunden ist, welches Rampen-Wellenformsignal (CAP A) zusammen mit einem Steuersignal, das eine geforderte Ausgangsspannung aus einer Leistungsversorgung repräsentiert, und mindestens einem anderen Signal (CONTROL A) an Mittel (2) eines Signalverarbeitungsnetzwerkes (2,4) (2,20) angelegt ist, das in der Lage ist, eine Pulsbreitenmodulation auszuführen durch Kombinieren jener Signale und Bereitstellen, aus der Kombination, eines repetitiven Ausgangssignals (OUTPUT A) mit einem ersten Pegel für einen ersten Teil seiner Periode und einem zweiten Pegel für den Rest seiner Periode.

## Revendications

1. Contrôleur d'alimentation électrique en mode commuté comportant un générateur de signal (1) qui, en fonctionnement, délivre un signal en forme d'onde de rampe se produisant de manière répétitive (CAP A), un réseau de traitement de signal (2, 4) (2, 20) et un moyen d'entrée (12) pour recevoir un signal de commande qui représente une tension de sortie requise provenant d'une alimentation, le réseau de traitement de signal (2, 4) (2, 20) comportant un moyen (2) pouvant effectuer une modulation de largeur d'impulsion en combinant le signal en forme d'onde de rampe (CAP A), le signal de commande et au moins un autre signal (COMMANDE A) et en délivrant à partir de la combinaison un signal de sortie répétitif (SORTIE A) ayant un premier niveau pendant une première partie de sa période et un second niveau pendant le reste de sa période, caractérisé en ce que le générateur (1) est conçu de manière à délivrer un signal en forme d'onde de rampe (CAP A) ayant des parties alternées en pente et à niveau constant, dans lequel chaque partie en pente s'étend au dessus et en dessous des parties à niveau constant adjacentes auxquelles elle est raccordée par des transitions abruptes.

2. Contrôleur selon la revendication 1, dans lequel le réseau de traitement de signal (2, 4) (2, 20) comporte un comparateur (50, 51, 63) ayant un premier accès d'entrée (67) connecté pour recevoir le signal (CAP A) à partir du générateur et un second accès d'entrée connecté pour recevoir le signal de commande, le comparateur (50, 51, 63) comportant un moyen (52, 53, 54, 55, 63) pour l'amener à commuter pour délivrer de manière régénérative les changements de signal de sortie et un moyen (52, 54, 56, 66) pour le remettre à l'état initial pour délivrer un signal de sortie au premier niveau sur l'arrivée de la transition abrupte au commencement de chaque forme d'onde en rampe (CAP A).

3. Contrôleur selon la revendication 2, dans lequel le comparateur (50, 51, 63) comporte un réseau de contre-réaction (52, 53, 54, 55, 63) pour effectuer la commutation régénérative et un réseau direct (52, 54, 56, 66 ) connecté entre ses régions d'entrée et de sortie pour le ramener à l'état initial sur l'arrivée de la transition abrupte au commencement de chaque forme d'onde en rampe (CAP A).

4. Contrôleur selon la revendication 3, dans lequel le réseau de contre-réaction (52, 53, 54, 55, 63) comporte des régions de sortie du comparateur (50, 51, 63).

5. Contrôleur selon la revendication 2, dans lequel le réseau de traitement de signal (2, 4, 7, 9) comporte un étage de sortie (9) relié directement à l'accès de sortie du comparateur, un réseau de contre-réaction (7) relié au comparateur et à l'étage de sortie (9) pour amener l'étage de sortie (9) à commuter de manière régénérative et un réseau direct relié entre les régions d'entrée et de sortie du comparateur pour remettre à l'état initial le comparateur sur l'arrivée de la transition abrupte au commencement de chaque forme d'onde en rampe.

6. Contrôleur selon la revendication 5, dans lequel le réseau de contre-réaction comporte des régions d'entrée de l'étage de sortie.

7. Contrôleur selon l'une quelconque des revendications 1 à 6, dans lequel le réseau de traitement de signal (2, 3, 4) comporte des premier et second canaux similaires, pour délivrer des premier (SORTIE A) et second (SORTIE B) signaux de sortie respectifs sur les premier et second canaux et des réseaux de commutation et de suppression (90, 91, 92, 93, 94, 95) sont connectés en shunt au réseau de traitement de signal pour sélectionner soit le premier signal de sortie (SORTIE A), soit le second signal de sortie (SORTIE B) pour transmission à un accès de sortie du contrôleur.

8. Contrôleur selon l'une quelconque des revendications 1 à 6, dans lequel le réseau de traitement de signal (2, 3, 4,) comporte des premier et second canaux pour délivrer des premier (SORTIE A) et second (SORTIE B) signaux de sortie respectifs sur les premier et second canaux et un réseau de commutation (120, 121, 122, 125) est connecté en shunt au réseau de traitement de signal pour combiner les premier (SORTIE A) et second (SORTIE B) signaux de sortie pour transmission à un accès de sortie du contrôleur.

9. Contrôleur selon l'une quelconque des revendications 1 à 8, dans lequel le réseau de traitement de signal comporte des réseaux de protection de limitation de courant et de tension (104, 105) et ces réseaux sont connectés en shunt au restant du réseau de traitement de signal.

10. Contrôleur selon l'une quelconque des revendications 1 à 9, dans lequel le réseau de traitement de signal comporte une pluralité d'étages à transistors montés différentiellement avec des accès d'entrée en mode commande, des accès d'entrée en mode différentiel et des accès de sortie en mode différentiel.

11. Contrôleur selon l'une quelconque des revendications 1 à 10, dans lequel le générateur de signal est un multivibrateur à émetteur couplé non-saturant (30 à 42) qui est connecté pour délivrer au réseau de traitement de signal un signal de rampe ayant des parties alternées de pente et de niveau constant raccordées par des transitions abruptes.

12. Contrôleur selon l'une quelconque des revendications 1 à 11, comportant un réseau de réglage du niveau de signal (70 à 76) monté pour ajuster la plage du signal de commande.

13. Utilisation dans un contrôleur d'alimentation électrique en mode commuté d'un générateur de signal (1) qui délivre un signal en forme d'onde en rampe se produisant de manière répétitive (CAP A) ayant des parties alternées de pente et de niveau constant, dans lequel chaque partie en pente s'étend au dessus et en dessous des parties à niveau constant adjacentes auxquelles elle est raccordée par des transitions abruptes, le signal en forme d'onde de rampe (CAP A) étant appliqué en même temps qu'un signal de commande, qui représente une forme de tension de sortie requise d'une alimentation et au moins un autre signal (COMMANDE A) est appliqué au moyen (2) d'un réseau de traitement de signal (2, 4) (2, 20) pouvant effectuer la modulation de largeur d'impulsion en combinant ces signaux et en délivrant à partir de la combinaison un signal de sortie répétitif (SORTIE A) ayant un premier niveau pendant une première partie de sa période et un second niveau pendant le reste de sa période.
